# EUROPEAN PATENT APPLICATION

(11) **EP 3 905 322 A1**
(43) Date of publication of application: **03.11.2021**
(21) Application number: 19902642.8
(22) Date of filing: 25.12.2019
(51) Int. Cl.: H01L 23/473, H05K 7/20

(54) **COOLING UNIT, METHOD FOR MANUFACTURING COOLING UNIT, AND STRUCTURE**

(30) Priority: 25.12.2018 JP 2018241444
(71) Applicant: Mitsui Chemicals, Inc., Minato-ku Tokyo 105-7122 (JP)
(72) Inventor: KURIYAGAWA Mizue, Sodegaura-shi, Chiba 299-0265 (JP); KIMURA Kazuki, Sodegaura-shi, Chiba 299-0265 (JP); NAKAJIMA Shinji, Sodegaura-shi, Chiba 299-0265 (JP); TOMINAGA Takahiro, Sodegaura-shi, Chiba 299-0265 (JP)
(74) Representative: J A Kemp LLP
(86) International application number: PCT/JP2019/050931
(87) International publication number: WO 2020/138211

(57) **Abstract**

A cooling unit (1) includes a resin tray (3), a metal plate (2) provided on one surface of the resin tray (3), and a flow path forming rib (5) provided in a space between the resin tray (3) and the metal plate (2), in which a top surface portion (3b) of a side wall portion (3a) of the resin tray (3) and the metal plate (2) are mechanically fastened via an elastic packing (4), the elastic packing (4) includes a bonding packing which is bonded to the metal plate (2) surface, and a fine uneven structure is formed on the metal plate (2) surface at least on a bonding portion with the bonding packing.

## Description

### TECHNICAL FIELD

The present invention relates to a cooling unit, a method for manufacturing a cooling unit, and a structure.

### BACKGROUND ART

In recent years, the miniaturization of electronic devices and secondary battery modules has progressed rapidly and the importance of heat management is increasing due to an increase in the amount of heat generated per unit volume (or unit area). Heat generation leads to a rise in the temperature of the device body or the battery body. Semiconductor devices, which play a central role in the operations inside electronic devices, are extremely sensitive to temperature and an increase in the temperature of the devices leads to a decrease in operating efficiency, malfunctions, and failures. In addition, even in a secondary battery, there is also a possibility that a high heat state exceeding the upper limit value of the operating temperature range may cause capacity deterioration and an increase in internal resistance, or may cause the battery to enter a state in which there is danger of explosion or the like. Accordingly, cooling techniques are important in order to control such heat generation by an external cooling means.

As a cooling system for such a heating element, liquid cooling systems using a refrigerant have become widespread in recent years. The background of the widespread use of the liquid cooling method is that it is possible to provide a heat exchanger at a relatively free position and the noise is also low. In a liquid cooling method cooling device, a cooling unit formed of a metal plate having a built-in flow path for circulating a refrigerant is brought into contact with a heating element, such as a secondary battery block, and heat generated from the heating element is transferred to a heat exchanger provided outside the device by the refrigerant which passes through the flow path, so as to cool the heating element (refer to, for example, Patent Document 1).

However, in such a cooling system, there is a possibility that the cooling unit may be deformed due to an external impact or deterioration, the sealed structure including the refrigerant flow path forming the cooling unit may be broken, and the refrigerant may leak. There is a concern that, for example, in the case of a secondary battery module, liquid leakage may induce a short circuit of the electrodes. In addition, there is a possibility that the refrigerant may leak and flood the circuit elements on the substrate. Accordingly, there is a demand for strict water leakage prevention in the refrigerant flow path of the cooling unit.

As a countermeasure, Patent Document 2 discloses a technique for ensuring liquid tightness by interposing a first seal portion and a second seal portion using O-rings between a cooling case through which a coolant flows and a heat radiation substrate on which a semiconductor element is mounted and pressing and contacting the cooling case and the heat radiation substrate in this state.

### RELATED DOCUMENT

### PATENT DOCUMENT

[Patent Document 1] Japanese Patent Application Publication No. 2016-029624
[Patent Document 2] Japanese Patent Application Publication No. 2001-308246

### SUMMARY OF THE INVENTION

### TECHNICAL PROBLEM

According to the technique disclosed in Patent Document 2, the first seal portion is provided on an outer peripheral side of a recess of the cooling case, through which the coolant flows, and the second seal portion is provided further on the outer peripheral side than the first seal portion. A groove portion for allowing liquid to escape is provided at a predetermined location on the cooling case positioned between the first seal portion and the second seal portion. Such a mechanism for preventing water leakage complicates the structure of the cooling unit and thus is not practical.

The present invention was made in view of the above circumstances and provides a cooling unit having excellent liquid tightness (for example, water tightness) capable of reducing the risk of refrigerant leakage.

### SOLUTION TO PROBLEM

According to the present invention, a cooling unit, a method for manufacturing a cooling unit, and a structure are provided, as shown below.

[1] A cooling unit including a resin tray, a metal plate provided on one surface of the resin tray, and a flow path forming rib provided in a space between the resin tray and the metal plate, in which a top surface portion of a side wall portion of the resin tray and the metal plate are mechanically fastened via an elastic packing, the elastic packing includes a bonding packing which is bonded to a metal plate surface, and a fine uneven structure is formed on at least a bonding portion with the bonding packing in the metal plate surface.
[2] The cooling unit according to [1], in which the elastic packing includes a thermoplastic elastomer.
[3] The cooling unit according to [2], in which the thermoplastic elastomer includes a urethane-based thermoplastic elastomer.
[4] The cooling unit according to [2] or [3], in which a tensile elastic modulus at 23°C of the elastic packing is 2 MPa or more and 500 MPa or less.
[5] The cooling unit according to any one of [1] to [4], in which the resin tray and at least a part of the flow path forming rib are integrally formed of the same material.
[6] The cooling unit according to any one of [1] to [5], in which the metal plate and at least a part of the flow path forming rib are integrally formed of the same material.
[7] The cooling unit according to any one of [1] to [6], in which at least one elastic packing is arranged around a contact surface of the metal plate surface with the top surface portion.
[8] The cooling unit according to any one of [1] to [7], in which the metal plate and the bonding packing are bonded by a portion of the bonding packing entering the fine uneven structure.
[9] The cooling unit according to any one of [1] to [8], in which the bonding packing is injection bonded to the metal plate.
[10] The cooling unit according to any one of [1] to [9], in which an entry percentage of the bonding packing into the fine uneven structure is 20% or more.
[11] The cooling unit according to any one of [1] to [10], in which the mechanical fastening includes at least one type selected from screwing and riveting.
[12] The cooling unit according to any one of [1] to [11], in which a top edge portion is formed on at least top surface portions of opposing side wall portions of the resin tray.
[13] The cooling unit according to any one of [1] to [12], in which the metal plate is formed of at least one member selected from the group consisting of an aluminum member, an aluminum alloy member, a copper member, and a copper alloy member.
[14] A manufacturing method for manufacturing the cooling unit according to any one of [1] to [13], the method including a step of injection bonding the bonding packing to the metal plate by injection molding the bonding packing on the fine uneven structure on the metal plate surface.
[15] A structure including a heating element, and the cooling unit according to any one of [1] to [13], in which the heating element is arranged on the metal plate surface in the cooling unit.

### ADVANTAGEOUS EFFECTS OF INVENTION

According to the present invention, it is possible to provide a cooling unit with excellent liquid tightness capable of reducing the risk of refrigerant leakage.

### BRIEF DESCRIPTION OF THE DRAWINGS

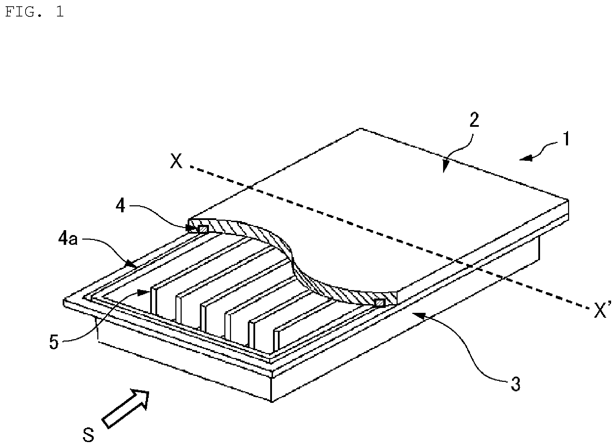

Fig. 1 is a partially broken perspective view schematically showing an example of a structure of a cooling unit according to an embodiment of the present invention.
Fig. 2 is an exploded perspective view schematically showing an example of the structure of the cooling unit according to a first embodiment of the present invention.
Fig. 3 is an exploded perspective view schematically showing an example of a structure of a cooling unit according to a second embodiment of the present invention.
Fig. 4 is a cross-sectional view of the vicinity of a fastening portion of the cooling unit according to an embodiment of the present invention.
Fig. 5 (a) is a cross-sectional view taken along X-X' of an example of the structure of the cooling unit according to the first embodiment of the present invention.
Fig. 5(b) is a cross-sectional view taken along X-X' of an example of the structure of the cooling unit according to the second embodiment of the present invention.
Fig. 5(c) is a cross-sectional view taken along X-X' of an example of the structure of the cooling unit according to a third embodiment of the present invention. Note that, the shapes and arrangements of the flow path forming ribs in each diagram of (a) to (c) are merely examples.
Fig. 6 is a diagram showing a cross-sectional photograph of a boundary portion between an elastic packing and a metal plate in a composite structure produced in Example 1.
Fig. 7 is a diagram showing a cross-sectional photograph of a boundary portion between an elastic packing and a metal plate in a composite structure produced in Comparative Example 1.
Fig. 8 is a diagram for illustrating a method for measuring an entry percentage into a fine uneven structure.

### DESCRIPTION OF EMBODIMENTS

A description will be given below of embodiments of the present invention with reference to the drawings. Note that, in all drawings, similar components are denoted by common reference numerals and description thereof will not be repeated, as appropriate. In addition, the figures are schematic views and do not match the actual dimensional ratios. In addition, unless otherwise specified, "to" between two numbers in the text represents "number one or more and number two or less".

### <Cooling Unit 1>

A cooling unit 1 according to the present embodiment is provided with a resin tray 3, a metal plate 2 provided on one surface of the resin tray 3, and a flow path forming rib 5 provided in a space between the resin tray 3 and the metal plate 2, in which a top surface portion 3b of a side wall portion 3a of the resin tray 3 and the metal plate 2 are mechanically fastened via an elastic packing 4, the elastic packing 4 includes a bonding packing which is bonded to the metal plate 2 surface, and a fine uneven structure is formed on the metal plate 2 surface at least on a bonding portion with the bonding packing.

In the cooling unit 1 according to the present embodiment, since the resin tray 3 and the metal plate 2 are mechanically fastened via the elastic packing 4 (bonding packing), the synergistic effect of the elastic packing 4 and the mechanical fastening makes it possible to reduce the risk of refrigerant leakage. That is, the cooling unit 1 according to the present embodiment is excellent in liquid tightness.

Furthermore, since the structure of the cooling unit 1 according to the present embodiment is simple, the practicality is also excellent.

Here, in the present embodiment, in the elastic packing 4, the elastic packing bonded to the metal plate 2 is referred to as the bonding packing. That is, the bonding packing is bonded to the metal plate 2 at a stage before the resin tray 3 and the metal plate 2 are mechanically fastened.

In the metal plate 2, since the entire metal plate is cooled by the refrigerant flowing through a flow path 7 formed in the resin tray 3, a heating element such as a battery cell or a semiconductor device in contact with the surface of the metal plate 2 opposite to the flow path is efficiently cooled. In addition, since a part of the cooling unit 1 is formed of the resin tray 3, it is possible to reduce the weight of the cooling unit 1 or the entire structure.

Note that, as a means for fastening the metal plate 2 and the resin tray 3, the present embodiment does not at all exclude the simultaneous use of a known fastening method other than the means of mechanical fastening via the elastic packing 4 for example, a method for bonding and fastening the metal plate 2 and the resin tray 3 using an adhesive. In other words, all cooling units including an aspect in which the metal plate 2 and the resin tray 3 are mechanically fastened via the elastic packing 4 are within the range of the scope of the present embodiment.

The cooling unit 1 according to the present embodiment is classified into the following three embodiments according to the difference in the material of the flow path forming rib 5, for example.

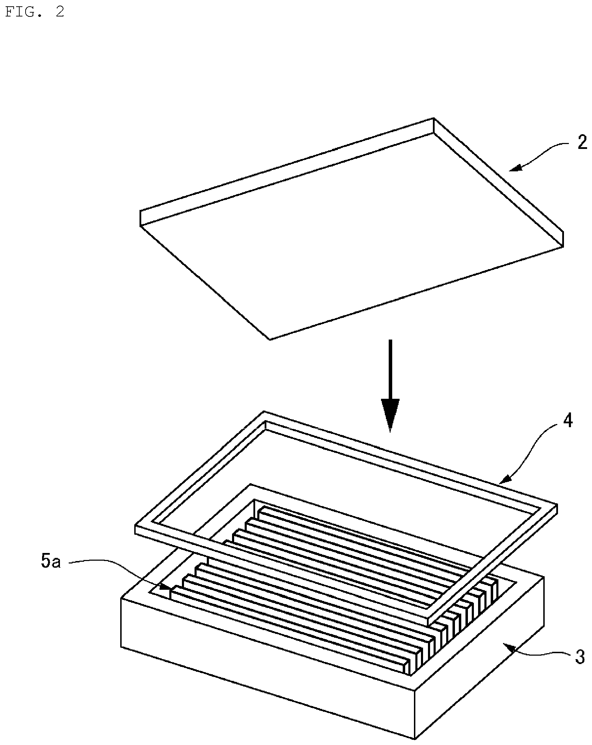

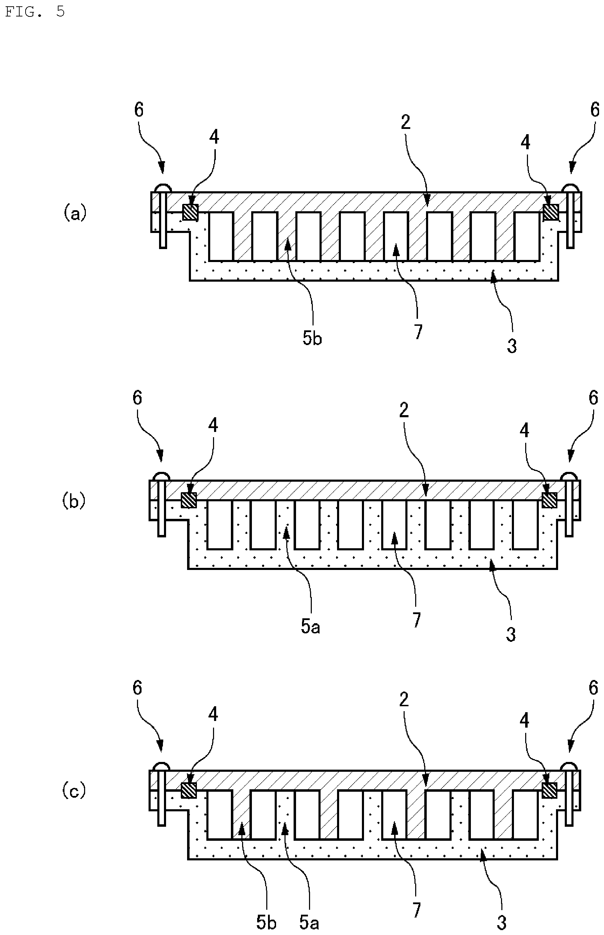

The first embodiment is a cooling unit in which the resin tray 3 and at least a part of the flow path forming rib 5 (resin flow path forming ribs 5a) are integrally formed of the same material (refer to Fig. 2, Fig. 5(b)).

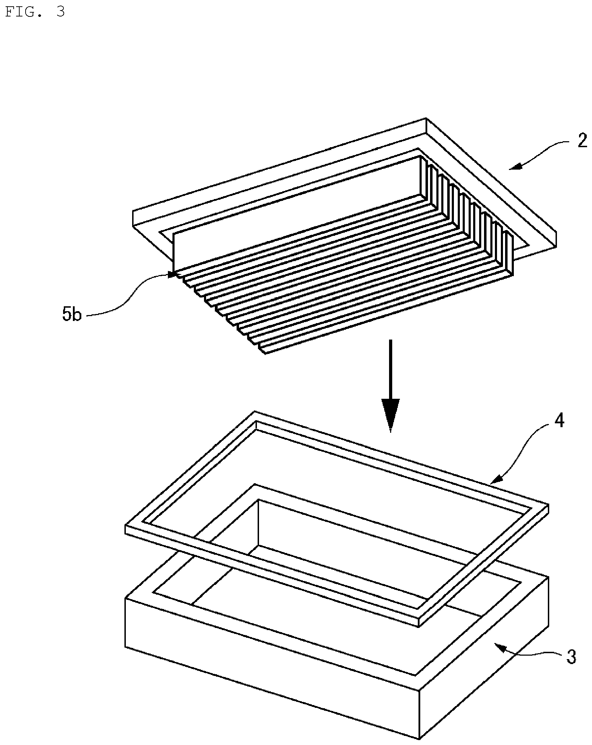

The second embodiment is a cooling unit in which the metal plate 2 and at least a part of the flow path forming rib 5 (metal flow path forming ribs 5b) are integrally formed of the same material (refer to Fig. 3, Fig. 5(a)).

The third embodiment is a cooling unit in which the flow path forming rib 5 includes both the resin flow path forming ribs 5a and the metal flow path forming ribs 5b (refer to Fig. 5(c)).

Among these embodiments, the first embodiment is preferable from the viewpoints of the ease of freely creating a flow path and the light weight property of the entire cooling unit 1.

In the cooling unit 1 according to the present embodiment, the elastic packing 4 is preferably arranged around the contact surface of the metal plate 2 surface with the top surface portion 3b. The number of elastic packings 4 may be one, or may be two or more. The above is a matter to be arbitrarily set by those skilled in the art depending on the usage environment of the cooling unit 1. In a case where a plurality of elastic packings 4 are used, normally, even if there is a water leak from the elastic packing arranged at the innermost circumference, another elastic packing is arranged around the outer circumference of the elastic packing so as to not intersect with the above packing, in order to make it possible to reliably block the water leakage. The packing may have a string shape having two ends or may have a loop shape having no ends; however, usually, it is preferable to use a loop shape. This is because, in the case of a string shape, there is a possibility that a gap may be formed between one end and the other end in a case where the elastic packing is arranged therearound.

In the present embodiment, the elastic packing 4 includes a bonding packing which is, for example, injection bonded or adhesive bonded to the surface of the metal plate 2. That is, in the case of one elastic packing 4, the elastic packing 4 is preferably injection bonded or adhesive bonded, and more preferably injection bonded. In a case of being formed of a plurality of elastic packings 4, at least one elastic packing 4 is preferably injection bonded or adhesive bonded as described below. Note that, in the present embodiment, "injection bonded" refers to a bonding state in which a shaped metal object is inserted into a mold, resin is injected therein, and the two are integrated, while "adhesive bonded" is defined as a bonded state in which a metal surface and a resin surface are bonded by a chemical or physical force or both through the medium of an adhesive.

The elastic packing 4 is injection bonded or adhesive bonded to the surface of the metal plate 2 in advance, due to this, in a case where the cooling unit 1 according to the present embodiment is assembled, it is possible to effectively avoid extreme decreases in assembly workability based on bending deformation and curl deformation of the elastic packing 4 often encountered in a case where there is no such bonding.

In the cooling unit 1 according to the present embodiment, the fine uneven structure described below is formed on the surface of the metal plate 2 at least on a bonding portion with the bonding packing. By forming such a fine uneven structure, the bonding strength formed by the injection bonding and adhesive bonding between the metal surface and the elastic packing surface or adhesive surface is increased and it is possible to effectively improve the liquid tightness of the interface. In addition, when such a fine uneven structure is formed on the surface of the metal plate 2, the metal plate 2 and the bonding packing are bonded by a portion of the bonding packing entering the fine uneven structure, making it possible to increase the bonding strength between the bonding packing surface and the metal surface and to effectively increase the liquid tightness of the interface. Furthermore, when such a fine uneven structure is formed on the surface of the metal plate 2, it is possible to absorb a difference in the linear expansion coefficient between the metal plate 2 and the elastic packing and to suppress a decrease in the bonding strength.

The entry percentage of the bonding packing into the fine uneven structure is preferably 20% or more, more preferably 30% or more, and even more preferably 40% or more. Due to this, it is possible to increase the bonding strength between the metal surface and the bonding packing surface and to effectively improve the liquid tightness of the interface.

In the cooling unit 1 according to the present embodiment, the metal plate 2 and the resin tray 3 are mechanically fastened via the elastic packing 4. The specific method for mechanically fastening is not particularly limited, but a fastening means using screwing or riveting is preferable in terms of being excellent in terms of economy and being able to maintain a firm fastening state for a long period of time. Examples of mechanical fastening methods also include a fastening means using a resin member. Examples of the fastening means using the resin member include a method of using a pre-molded resin member instead of the screwing or riveting described above, a method of fastening the metal plate 2 and the resin tray 3 by injection molding of the resin member by two-color molding or the like, and the like.

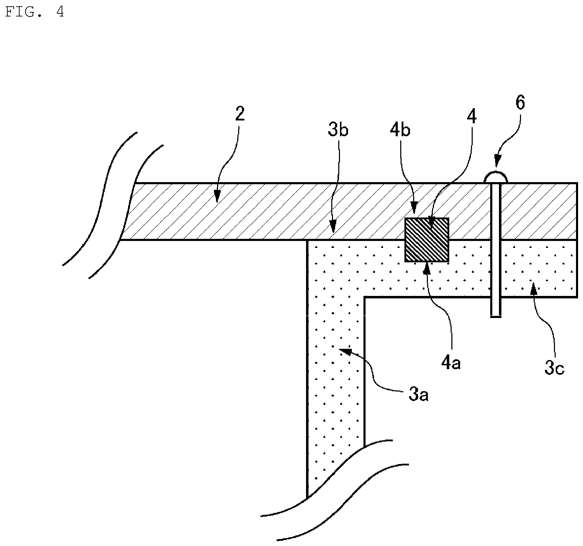

In the present embodiment, as shown in Fig. 4, a top edge portion 3c is preferably formed on at least one set of opposing side wall portions 3a (two sides) of the resin tray 3, preferably two sets of side wall portions 3a (four sides), that is, all the top surface portions 3b of all side wall portions. By providing the top edge portion 3c, it is possible to increase the area of the contact portion between the metal plate 2 and the resin tray 3 at the fastening portion and to provide a cooling unit capable of reducing the risk of refrigerant leakage as a result. In addition, there are also advantages in that the presence of the top edge portion 3c imparts flexibility to the number of mechanical fastening points, and, when performing the mechanical fastening operation, as a result of creating a space margin, it is possible to reduce the risk of human error.

A description will be given below of the elastic packing 4, the resin tray 3, and the metal plate 2 forming the cooling unit 1 in order and then an example of a method for forming the cooling unit 1 from these components will be shown.

### <Elastic Packing 4>

The elastic packing 4 according to the present embodiment preferably includes a thermoplastic elastomer (TPE). The TPE according to the present embodiment is an elastic material which does not need to be vulcanized like rubber and is generally a material formed of a hard component (hard and rigid component) and a soft component (soft and flexible component) . Many types of TPEs are known and examples of preferable TPEs according to the present embodiment include olefin-based TPEs, amide-based TPEs, styrene-based TPEs, polyester-based TPEs, urethane-based TPEs, and the like.

Among these TPEs, from the viewpoint of adhesive strength, sealing characteristics, and flexibility and repulsion characteristics as packing, it is more preferable to include a urethane-based TPE (also referred to below as TPU) and an amide-based TPE (also referred to below as TPAE) . The content of TPE in the elastic packing 4 is, for example, 60% by mass or more and 100% by mass or less, and preferably 65% by mass or more and 99% by mass or less. A more preferable aspect of the elastic packing 4 according to the present embodiment includes both the TPU and the TPAE. The total content of the TPU and the TPAE in the elastic packing 4 is, for example, 60% by mass or more and 100% by mass or less, preferably 65% by mass or more and 95% by mass or less, and more preferably 70% by mass or more and 95% by mass or less. The total content of TPU and TPAE in the elastic packing 4 being 60% by mass or more makes it possible to improve the elastic function required for a sealing material such as elastic packing, which is preferable.

In the present embodiment, the content of TPU in the elastic packing 4 is, for example, 70% by mass or more and less than 100% by mass, preferably 70% by mass or more and 99% by mass or less, and more preferably 75% by mass or more and 98% by mass or less, while on the other hand, the content of TPAE is, for example, more than 0% by mass and 30% by mass or less, preferably 1% by mass or more and 30% by mass or less, and more preferably 2% by mass or more and 25% by mass or less. By setting the content of TPU in the elastic packing 4 to the above lower limit values or more, it is possible to ensure the chemical resistance of the elastic packing 4 according to the present embodiment, particularly the acid resistance, and by setting the content of TPAE in the elastic packing 4 to the above lower limit values or in excess thereof, it is possible to improve the elasticity of the elastic packing 4.

TPU is, for example, a multi-block polymer formed of a hard segment formed of diisocyanate and a short chain glycol (chain extender) and a soft segment mainly formed of a polymer glycol having a number average molecular weight of approximately 1000 to 4000.

Examples of the diisocyanate include aromatic isocyanates typified by 4,4'-diphenylmethane diisocyanate (MDI), and the like. Aliphatic isocyanates such as hexamethylene diisocyanate (HDI) or the like are also appropriately used in applications requiring weather resistance.

Examples of short chain glycols include ethylene glycol, 1,3-propanediol, 1,4-butanediol, 1,6-hexanediol, diethylene glycol, tetraethylene glycol, neopentyl glycol, 1,4-cyclohexanedimethanol, mixtures thereof, and the like.

Examples of the polymer glycol include a polyether polyol typified by polytetramethylene ether glycol (PTMEG), a polyester polyol which is a condensation-based polymer of adipic acid and an aliphatic or aromatic glycol, a polycaprolactone polyol obtained by ring-opening polymerization of ε-caprolactone, and the like.

Depending on what kind of components are used as the diisocyanate component, the short chain glycol, and the polymer glycol, the TPU is classified into an ether type, an adipate ester type, a caprolactone type, a carbonate type, or the like; however, in the present embodiment, it is possible to use the TPUs described above without limitation.

Various TPUs are commercially available from many companies under various brand names, for example, RESAMINE P (trademark) of Dainichiseika Color & Chemicals Mfg. Co., Ltd., PANDEX (trademark) of DIC Covestro Polymer Ltd., MIRACTRAN (trademark) of Tosoh Corporation, PELLETHANE (trademark) of Dow Chemical Company, ESTANE (trademark) of B.F. Goodrich Corporation, DESMOPAN (trademark) of Bayer, and the like are commercially available. It is possible to use these commercially available products without limitation.

TPAE means that there is an amide bond (-CONH-) in the polymer main chain forming the hard segment. Examples of TPAE include an amide-based thermoplastic elastomer (TPA) defined in JIS K6418: 2007 or the like and a polyamide-based elastomer described in Japanese Patent Application Publication No. 2004-346273 or the like.

Examples of the TPAE described above include a material in which at least polyamide forms a hard segment having crystallinity and a high melting point while another polymer (for example, polyester, polyether, or the like) forms a soft segment having amorphousness and a low glass transition temperature. In addition, as TPAE, a chain length extender such as a dicarboxylic acid may be used in addition to the hard segment and the soft segment. Examples of the polyamide forming the hard segment include a polyamide produced by ring-opening polycondensation of ω-aminocarboxylic acid such as 6-aminocaproic acid and a lactam such as ε-caprolactam.

In addition, examples of the polymer forming the soft segment include polyester and polyether, examples of the polyether include polyethylene glycol, polypropylene glycol, polytetramethylene ether glycol, an ABA-type triblock polyether, and the like, and it is possible to use these alone or in a combination of two or more types.

In addition, it is possible to use a polyether diamine or the like obtained by reacting ammonia or the like with the terminal of the polyether.

Examples of the combinations of the hard segment and the soft segment include each combination of the hard segment and the soft segment exemplified above. Among these, a combination of lauryl lactam ring-opening polycondensate/polyethylene glycol, a combination of lauryl lactam ring-opening polycondensate/polypropylene glycol, a combination of lauryl lactam ring-opening polycondensate/polytetramethylene ether glycol, and a combination of lauryl lactam ring-opening polycondensate/ABA-type triblock polyether are preferable, and a combination of lauryl lactam ring-opening polycondensate/ABA-type triblock polyether is particularly preferable.

As the TPAE, it is possible to use Pebax 33 series of Arkema (for example, 7233, 7033, 6333, 5533, 4033, MX1205, 3533, and 2533), "UBESTA XPA" series of Ube Industries, Ltd. (for example, XPA9063X1, XPA9055X1, XPA9048X2, XPA9048X1, XPA9040X1, XPA9040X2, and the like), "Vestamid" series of Daicel Evonik Ltd. (for example, E40-S3, E47-S1, E47-S3, E55-S1, E55-S3, EX9200, and E50-R2), and the like.

The elastic packing 4 according to the present embodiment preferably further includes an acid-modified polymer. The content of the acid-modified polymer in the elastic packing 4 according to the present embodiment is preferably 1 part by mass or more and 35 parts by mass or less with respect to a total of 100 parts by mass of the TPU and the TPAE, and more preferably 3 parts by mass or more and 30 parts by mass or less, and even more preferably 5 parts by mass or more and 25 parts by mass or less.

The present inventors confirmed that the melt fluidity of the elastic packing 4 is remarkably improved by the acid-modified polymer being contained at at least the above lower limit value. This fact provides great process advantages in a case where the composite structure of the elastic packing 4 and the metal plate 2 according to the present embodiment is manufactured by injection molding, that is, in a case of carrying out the manufacturing by injection bonding. Specifically, even in a case where a mold having a long moving distance from a molten resin gate is used, it is possible to obtain a composite structure having a high bonding strength effectively and with good reproducibility.

The acid-modified polymer according to the present embodiment is, for example, a polymer containing a carboxylic acid and/or a carboxylic acid anhydride group. In the present embodiment, as the acid-modified polymer, an acid-modified polyolefin resin containing a skeleton derived from an olefin component and an unsaturated carboxylic acid component is preferably used. Various acid-modified polymers are commercially available and examples thereof include Nucrel (registered trademark) series, which is an acid-modified polyolefin resin manufactured by Mitsui-Dupont Polychemical Co., Ltd., Himilan (registered trademark) series, which is an ionomer resin thereof, Kurarity (registered trademark) series, which is an acrylic block copolymer manufactured by Kuraray Co., Ltd., Modic (registered trademark) series, which is an acid-modified polyolefin resin manufactured by Mitsubishi Chemical Corporation, Admer (registered trademark) series, which is an acid-modified polypropylene manufactured by Mitsui Chemicals, Inc., Rexpearl (registered trademark) series, which is an acid-modified polyethylene resin manufactured by Japan Polyethylene Corporation, Bondine (registered trademark) series, which is a maleic anhydride-modified polyolefin resin manufactured by Arkema, and the like.

The tensile elastic modulus of the elastic packing at 23°C is preferably 2 MPa or more and 500 MPa or less from the viewpoint of liquid tightness. Further, the tensile elastic modulus of the bonding packing at 23°C is preferably 2 MPa or more and 500 MPa or less from the viewpoint of liquid tightness.

### <Resin Tray 3>

The resin tray 3 according to the present embodiment is preferably a molded product of a thermoplastic resin composition. The thermoplastic resin composition includes a thermoplastic resin as a resin component and may further include a filler as necessary.

The thermoplastic resin is not particularly limited and examples thereof include polymethacryl-based resins such as a polyolefin-based resin, a polar group-containing polyolefin-based resin, and a polymethylmethacrylate resin, polyacryl-based resins such as a polymethylacrylate resin, aromatic polyether ketones such as a polystyrene resin, a polyvinyl alcohol-polyvinyl chloride copolymer resin, a polyvinyl acetal resin, a polyvinyl butyral resin, a polyvinyl formal resin, a polymethylpentene resin, a maleic anhydride-styrene copolymer resin, a polycarbonate resin, a polyphenylene ether resin, a polyether ether ketone resin, and a polyether ketone resin, polyester-based resins, polyamide-based resins, polyamideimide resins, polyimide resins, polyetherimide resins, styrene-based elastomers, polyolefin-based elastomers, polyurethane-based elastomers, polyester-based elastomers, polyamide-based elastomers, ionomers, aminopolyacrylamide resins, isobutylene maleic anhydride copolymers, ABS, ACS, AES, AS, ASA, MBS, ethylene-vinyl chloride copolymers, ethylene-vinyl acetate copolymers, ethylene-vinyl acetate-vinyl chloride graft polymers, ethylene-vinyl alcohol copolymers, chlorinated polyvinyl chloride resin, chlorinated polyethylene resin, chlorinated polypropylene resin, carboxyvinyl polymer, ketone resin, amorphous copolyester resin, norbornene resin, fluoroplastic, polytetrafluoroethylene resin, fluorine ethylene polypropylene resin, PFA, polychlorofluoroethylene resin, ethylene tetrafluoroethylene copolymer, polyvinylidene fluoride resin, polyvinyl fluoride resin, polyarylate resin, thermoplastic polyimide resin, polyvinylidene chloride resin, polyvinyl chloride resin, polyvinyl acetate resin, polysulfone resin, polyparamethylstyrene resin, polyallylamine resin, polyvinyl ether resin, polyphenylene oxide resin, polyphenylene sulfide (PPS) resin, polymethylpentene resin, oligoester acrylate, xylene resin, maleic acid resin, polyhydroxybutyrate resin, polysulfone resin, polylactic acid resin, polyglutamic acid resin, polycaprolactone resin, polyethersulfone resin, polyacrylonitrile resin, styrene-acrylonitrile copolymer resin, and the like. These thermoplastic resins may be used as one type alone or in a combination of two or more types.

Among these, as the thermoplastic resin, from the viewpoint of being able to more stably and effectively obtain the effect of maintaining the mechanical strength of the resin tray 3 against bias from the outside and/or the inside, or improving the bonding strength between the resin tray 3 and the metal plate 2, it is suitable to use one type or two or more types of thermoplastic resins selected from polyolefin-based resins, polyester-based resins, polyamide-based resins, fluorine-based resins, polyarylene ether-based resins, and polyarylene sulfide-based resins.

In the thermoplastic resin composition according to the present embodiment, it is possible to use an arbitrary component and a filler in combination from the viewpoint of improving the mechanical properties of the resin tray 3, adjusting the difference in the coefficient of linear expansion, and the like. As the filler, for example, it is possible to select one or more kinds from the group consisting of glass fiber, carbon fiber, carbon particle, clay, talc, silica, minerals, and cellulose fiber. Among these, one type or two or more types selected from glass fiber, carbon fiber, talc, and minerals are preferable. In addition, it is also possible to use a heat-dissipating filler typified by alumina, forsterite, mica, alumina nitride, boron nitride, zinc oxide, magnesium oxide, and the like. The shape of these fillers is not particularly limited and may be any shape such as fibrous, particulate, or plate-like; however, as will be described below, in a case where a fine uneven structure is formed on the surface of the metal plate 2, it is preferable to use a filler having a size able to penetrate into the fine recesses.

Note that, in a case where the thermoplastic resin composition includes a filler, the content thereof is preferably 1 part by mass or more and 100 parts by mass or less with respect to 100 parts by mass of the thermoplastic resin, more preferably 5 parts by mass or more and 90 parts by mass or less, and particularly preferably 10 parts by mass or more and 80 parts by mass or less.

It is also possible to use a thermosetting resin composition as the resin tray 3 according to the present embodiment. The thermosetting resin composition is a resin composition including a thermosetting resin. As the thermosetting resin, for example, phenol resin, epoxy resin, unsaturated polyester resin, diallyl phthalate resin, melamine resin, oxetane resin, maleimide resin, urea resin, polyurethane resin, silicone resin, resins having a benzoxazine ring, cyanate ester resins, and the like are used. These may be used alone or in a combination of two or more types.

Among these, from the viewpoints of heat resistance, processability, mechanical properties, adhesiveness, rust resistance, and the like, a thermosetting resin composition including one or more selected from the group consisting of phenol resins, epoxy resins, and unsaturated polyester resins is preferably used. The content of the thermosetting resin in the thermosetting resin composition is preferably 15 parts by mass or more and 60 parts by mass or less when the entire resin composition is 100 parts by mass, and more preferably 25 parts by mass or more and 50 parts by mass or less. The residual component is, for example, a filler, and as the filler, for example, it is possible to use the fillers described above.

It is possible to use known methods without limitation as the molding method of the resin tray 3 and possible examples thereof include injection molding, extrusion molding, heat press molding, compression molding, transfer molding, casting molding, laser welding molding, reaction injection molding (RIM molding), liquid injection molding (LIM molding), spray molding, and the like. Among these, as the method for manufacturing the resin tray 3, the injection molding method is preferable from the viewpoint of productivity and quality stability.

Using this method, it is possible to easily manufacture the resin tray 3 in which at least a part of the flow path forming rib 5 is integrally formed of the same material as the resin tray 3 (first embodiment) and the container-shaped resin tray 3 in which the flow path forming rib 5 is not formed inside a tray (second embodiment) .

In the top surface portion 3b of the side wall portion 3a of the resin tray 3, a resin tray side concave groove 4a for an elastic packing is preferably formed such that it is possible for the elastic packing 4 bonded to the peripheral edge of the surface of the metal plate 2 is reliably embedded and tightly engaged therein.

### <Metal Plate 2>

The metal plate 2 forming the cooling unit 1 according to the present embodiment plays two roles of diffusing heat from a heating element such as a lithium-ion battery and efficiently transferring heat to the refrigerant flowing in the resin tray 3. Therefore, it is preferable that the metal species forming the metal plate 2 have excellent heat transfer properties. From this point of view, an aluminum-based metal or a copper-based metal is used as the metal forming the metal plate 2, and specifically, the metal is preferably formed of at least one member selected from the group consisting of an aluminum member, an aluminum alloy member, a copper member, and a copper alloy member. Among these, aluminum alloy members and/or copper alloy members are more preferable. In addition, in consideration of heat transferability, strength, and lightness as a whole, the average thickness of the metal plate 2 is, for example, 0.5 mm to 30 mm, and preferably 0.5 mm to 20 mm.

It is more preferable that a hydrophilic group is further formed on the surface of the metal plate 2 on which the fine uneven structure is formed. By doing so, it is possible to increase the bonding strength between the elastic packing 4 (bonding packing) and the metal plate 2 and, as a result, it is possible to further suppress refrigerant leakage and to obtain the cooling unit 1 in which the reliability of the mechanical strength and durability are superior.

In a preferable aspect (first aspect) of the metal plate 2 according to the present embodiment, the profile (depth, pore diameter, inter-pore distance, and the like) of the fine uneven structure formed on the metal surface is not particularly limited; however, usually, the ten-point average roughness Rzjis measured according to JIS B 0601: 2001 (corresponding to ISO4287) is, for example, 1 µm or more, preferably 1 µm or more and 1 mm or less, and more preferably 3 µm or more and 100 µm or less.

The method for forming the fine uneven structure on the metal surface of the metal plate 2 is not particularly limited and examples thereof include a method in which the metal plate 2 is immersed in an inorganic base aqueous solution such as sodium hydroxide and/or an inorganic acid aqueous solution such as hydrochloric acid or nitrate; a method of processing the metal plate 2 by the anodization method; mechanical cutting; a method for forming a fine uneven structure on the surface of the metal plate 2 by, for example, pressing a mold punch having irregularities produced by diamond abrasive grain grinding or blasting on the surface of the metal plate 2; a method for forming a fine uneven structure on the surface of the metal plate 2 by sandblasting, knurling processing, or laser processing; a method of immersing the metal plate 2 in one or more aqueous solutions selected from hydrazine hydrate, ammonia, and a water-soluble amine compound, as disclosed in PCT International Publication No. 2009/31632 WO; and the like.

Note that, among the above methods, in particular, in a case where the immersion method is adopted, the fine uneven structure on the metal plate 2 is formed not only on the contact surface with the resin tray 3, but also on the entire surface of the metal plate 2; however, this embodiment does not limit the scope of the present invention at all.

Specific examples of the hydrophilic group covering the metal surface in another preferable aspect (second aspect) of the metal plate 2 according to the present embodiment include a hydroxyl group or a silanol group. It is possible to achieve the introduction of hydrophilic groups such as hydroxyl groups into the metal surface, for example, by implementing plasma surface modification techniques which appropriately combine Openair (trademark) and PlasmaPlus (trademark) techniques developed by Plasmatreat. In addition, for the introduction of the silanol groups into the metal surface, for example, functional group introduction is possible by an itro treatment (silicon oxidizing flame treatment) as described in Japanese Patent No. 3557194. In order to further introduce a hydroxyl group or a silanol group into the metal surface on which the fine uneven structure is formed, the fine uneven structure may be formed on the metal surface by the method described above and then a plasma or itro treatment may be further performed.

As described above, the metal plate 2 and the elastic packing 4 according to the present embodiment are preferably injection bonded or adhesive bonded. In order to be able to bond the bonded elastic packing more firmly to the metal plate 2 and to reliably prevent position shifting due to displacement from the outside on the metal plate from occurring, a metal plate side concave groove 4b for an elastic packing may be formed on the metal plate in a laying section for the elastic packing 4 to form a structure in which the elastic packing 4 is reliably embedded.

In the method for preparing the cooling unit 1 (second embodiment) formed of the metal plate 2 provided with the metal flow path forming rib 5b integrally formed of the same material as the metal plate 2, or the cooling unit 1 in which the flow path forming rib 5 includes both the resin flow path forming rib 5a and the metal flow path forming rib 5b, it is necessary to prepare the metal flow path forming rib 5b integrally formed of the same material as the metal plate 2 on the metal plate 2 before or after the surface treatment of the metal described above. Examples of such a preparing method include a known method of cutting a metal block using a rotating device such as a multi-cutter to form the metal flow path forming rib 5b. Usually, a multi-cutter is formed of a rotating shaft and a plurality of disk cutters arranged side by side on the rotating shaft and the disk cutters are arranged side by side with gaps therebetween. Here, the gap spacing between the adjacent disk cutters is equal to the thickness of the metal flow path forming rib 5b and the thickness of the disk cutters is the same as the distance between the adjacent ribs, that is, the width of the flow path 7.

### <Assembly Method (Manufacturing Method) of Cooling Unit 1>

For the cooling unit 1 according to the present embodiment, for example, assembly is possible by adhesive bonding (method A) in which the following element steps are executed in the order of 1 - 2 - 3 - 4 or injection bonding (method B) in which the following element steps are executed in the order of 1 - 3 - 4.

The adhesive bonding of method A is a method involving an adhesive between the metal and the elastic packing, while method B is a method involving injection bonding. A detailed description will be given below of the assembly method for methods A and B only.
1. Preparation of resin tray 3
2. Separately secure elastic packing 4
3. Preparation of metal plate 2 in which elastic packing 4 is injection bonded or adhesive-bonded
4. Mechanical fastening via packing between the top surface portion of the side wall portion of the resin tray 3 and the metal plate 2

Typical examples of the method A include a method (adhesive bonding) for carrying out the molding by bonding the metal plate 2 and the string-shaped or loop-shaped elastic packing 4 prepared by a molding means such as separate injection molding, via an adhesive. The method A preferably includes a step of coating an adhesive on the fine uneven structure on the surface of the metal plate 2 by a known method.

In method B, the cooling unit 1 according to the present embodiment is assembled by mechanically fastening the resin tray 3 prepared by the method described above and the metal plate 2 with elastic packing. Typical examples of the method for manufacturing the metal plate 2 with elastic packing include a method of insert molding (injection bonding) a resin composition which is a raw material of the elastic packing 4 on the metal plate 2. The method B preferably includes a step of injection molding the bonding packing on the fine uneven structure on the surface of the metal plate 2.

In a case of injection bonding, a mold for injection molding is prepared, the mold is opened, and the metal plate 2 is installed on a part thereof. Thereafter, the mold is closed and the resin composition is injected into the mold and solidified such that at least a part of the resin composition for an elastic packing is in contact with the surface of the metal plate 2. Thereafter, it is possible to obtain the metal plate 2 with elastic packing by opening the mold and releasing from the mold.

In addition, during the injection molding described above, it is preferable to use high-speed heat cycle molding (RHCM, heating and cooling molding) in which the mold is rapidly heated and cooled. This is because it is possible to increase the bonding strength between the metal and the resin by adopting the high-speed heat cycle molding. Specifically, it is possible to illustrate a method in which the surface temperature of the mold is maintained at a temperature of 250 to 300°C from the start of injection of the resin composition to the completion of holding pressure and then the surface temperature of the mold is cooled to 170 to 230°C.

As the adhesive used in a case of adhesive bonding, it is possible to use known natural adhesives and synthetic adhesives without limitation. What kind of adhesive is used is a matter to be arbitrarily determined by a person skilled in the art depending on the circumstances such as what kind of performance the cooling unit has and what kind of application the cooling unit is to be used for. Adhesive conditions vary depending on the type of adhesive, but for example, it is possible to illustrate conditions of approximately 0.1 minutes to 7 days at a temperature of room temperature to 150°C. The adhesion may be performed under pressure. In a case where the adhesion is performed under pressure, the pressure is, for example, approximately 0.01 to 1 MPa.

In this manner, it is possible to obtain the cooling unit 1 according to the present embodiment in which the top surface portion 3b of the side wall portion 3a of the resin tray 3 and the metal plate 2 with elastic packing are mechanically fastened. That is, in the cooling unit 1 according to the present embodiment, in the resin tray 3 and the metal plate 2, it is preferable that at least the resin tray 3 and the outer peripheral ends of the cooling unit 1 are mechanically fastened. Among mechanical fastenings, at least one type selected from screwing and riveting is preferable. The cooling unit formed by injection bonding or adhesive bonding the metal plate 2 and the elastic packing 4 and then mechanically fastening the resin tray 3 so as to pinch and compress the elastic packing as in method B is firmly fastened at two stages, thus, it is possible to more effectively suppress leakage of the refrigerant flowing in the resin tray 3. In addition, the cooling unit 1 according to the present embodiment, it is possible to easily handle cases of disassembling and refitting the cooling unit in order to deal with unexpected failures of the cooling unit and to periodically inspect the flow path in the cooling unit.

### <Structure>

A structure according to the present embodiment is provided with a heating element, the cooling unit 1 according to the present embodiment, and a case for accommodating the heating element as necessary and the heating element is arranged on the surface of the metal plate 2 in the cooling unit 1. The heating element is, for example, a battery or an electronic component. The metal plate 2 and the heating element may be brought into direct contact with each other; however, a heat conductive sheet is preferably interposed at the contact portion. Instead of a heat conductive sheet, a substance called a so-called thermal interface material (TIM) may be used, specifically, it is possible to illustrate thermal grease, a phase change material (PCM), gel, a high heat conductive adhesive, thermal tape, and the like.

Embodiments of the present invention were described above; however, these are examples of the present invention and various configurations other than the above are included.

### [Examples]

A description will be given below of embodiments of the present invention with reference to Examples, but the present embodiment is not limited thereto.

### (Measurement of 10-Point Average Roughness (Rzjis) of Metal Plate Surface)

Using the surface roughness measuring device "Surfcom 1400D (manufactured by Tokyo Seimitsu Co., Ltd.)", the ten-point average roughness (Rzjis) was measured from the surface roughness measured in accordance with JIS B0601: 2001 (corresponding to ISO4287) . Note that, the measurement conditions are as follows.
- Radius of stylus tip: 5 µm
- Standard length: 0.8 mm
- Evaluation length: 4 mm
- Measurement speed: 0.06 mm/sec

The measurement was performed on a total of 6 straight line parts formed of any 3 straight line parts parallel to each other on the surface of the metal plate and any 3 straight line parts orthogonal to the straight line parts.

### (Measurement of Tensile Elastic Modulus)

The tensile elastic modulus of the elastic packing was measured using a tensile tester in accordance with JIS K6254 (2016) under the conditions of a measurement temperature of 23°C, 50% RH, and a tensile speed of 50 mm/min.

### (Measurement of Entry Percentage of Elastic Packing into Fine Uneven Structure)

The entry percentage of the elastic packing into the fine uneven structure was measured by the following method.

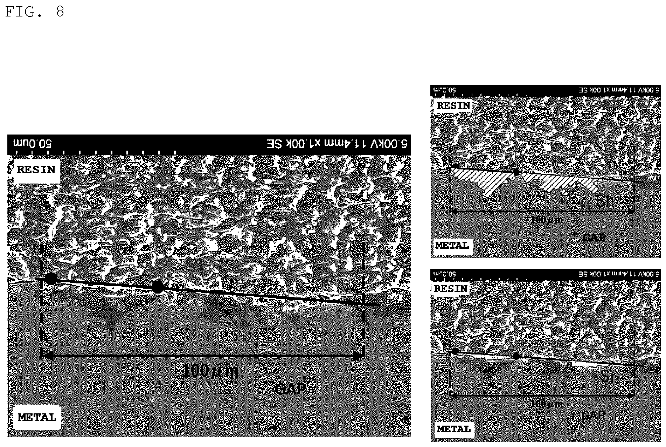

First, a cross-sectional photograph of the boundary portion between the elastic packing and the metal plate was taken. Next, from the obtained cross-sectional photograph, as shown in Fig. 8, the top two points of the height of the convex portion on the metal plate surface at the measurement length of 100 µm were connected by a straight line, an area Sh surrounded by the straight line and the metal interface and an area Sr of the resin portion existing in the region surrounded by the straight line and the metal interface were measured by image analysis software (software name: imageJ), and Sr/Sh × 100 [%] was defined as the entry percentage. Here, the entry percentage was measured at a total of 5 points in one measurement sample and the average value thereof was adopted.

### (Air Tightness Evaluation)

In accordance with ISO19095, a helium leak test was conducted and a helium gas detection amount of less than 10 ppm was a pass and a helium gas detection amount of 10 ppm or more was a failure.

### <Resin Composition>

As a resin composition A1, Resamine P™ (grade name P2275, manufactured by Dainichiseika Color & Chemicals Mfg. Co., Ltd.), which is an ether-based thermoplastic polyurethane (TPU), was used.

<Production of Surface-Roughened Metal Plate>

### (Surface-Roughened Aluminum Alloy Plate M1)

An aluminum alloy plate (45 mm × 18 mm × 2 mm) with alloy number 6063 specified in JIS H4000 was subjected to a degreasing process, then immersed for 3 minutes in a treatment tank 1 filled with an alkali-based etching agent (30°C) containing 15% by mass of sodium hydroxide and 3% by mass of zinc oxide (may be abbreviated as "alkali-based etching agent treatment" in the following description), then immersed for 1 minute in 30% by mass nitric acid (30°C), and the alkali-based etching agent treatment was repeated one more time. Next, the obtained aluminum alloy plate was immersed for 5 minutes in a treatment tank 2 filled with an acid-based etching aqueous solution containing 3.9% by mass of ferric chloride, 0.2% by mass of cupric chloride, and 4.1% by mass of sulfuric acid, at 30°C and subjected to oscillation. Next, ultrasonic cleaning (1 minute in water) was performed with running water, and then the surface-roughened aluminum alloy plate M1 was obtained by drying.

For the surface roughness of the surface-roughened aluminum alloy plate M1, the ten-point average roughness (Rzjis) was measured from among the surface roughness measured in accordance with JIS B0601: 2001 (corresponding to ISO4287) using the surface roughness measuring device "Surfcom 1400D (manufactured by Tokyo Seimitsu Co., Ltd.) ". As a result, the average value of Rzjis was 20 µm. Note that, the Rzjis average value is an average value of the measured values of 6 points at different measurement locations.

### [Example 1]

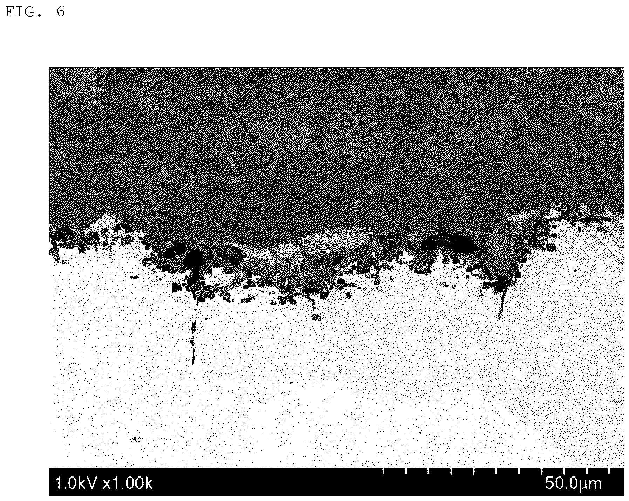

A leak test mold was mounted on J85AD110H manufactured by Japan Steel Works, Ltd. and the surface-roughened aluminum alloy plate M1 obtained by the above method was installed in the mold. Next, the resin composition A1 was injection molded into the mold under the conditions of a cylinder temperature of 190°C, a mold temperature of 40°C, an injection speed of 25 mm/sec, a holding pressure of 80 MPa, and a holding pressure time of 10 seconds and a composite structure formed of the surface-roughened aluminum alloy plate M1 and the bonding packing formed of the resin composition A1 was produced. Further, a test piece for a leak test was obtained by mechanically fastening the surface-roughened aluminum alloy M1 with a screw via a bonding packing formed of the resin composition A1 obtained by molding in advance. Fig. 6 shows a cross-sectional photograph of the boundary portion between the bonding packing and the metal plate in the obtained test piece. The entry percentage of the bonding packing into the fine uneven structure, as calculated from the photograph of Fig. 6, was 40%. The air tightness of the obtained composite structure was evaluated as a pass.

In addition, the tensile elastic modulus at 23°C of the elastic packing formed of the resin composition A1 was 9 MPa.

### [Comparative Example 1]

Using an injection molding machine, the resin composition A1 was injection molded under the conditions of a cylinder temperature of 190°C, a mold temperature of 40°C, an injection speed of 25 mm/sec, a holding pressure of 80 MPa, and a holding pressure time of 10 seconds and an elastic packing was produced.

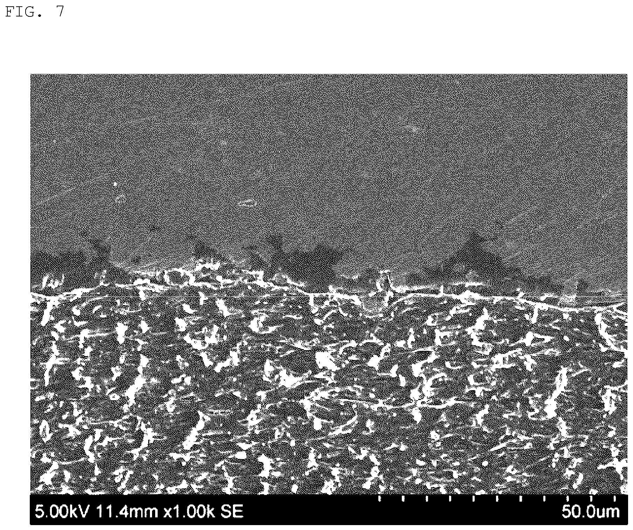

Next, the obtained elastic packing was overlaid on the surface-roughened aluminum alloy plate M1, the elastic packing formed of the resin composition A1 was further overlaid thereon, and the elastic packing and the surface-roughened aluminum alloy M1 were mechanically fastened with screws to produce a test piece for a leak test. Fig. 7 shows a cross-sectional photograph of the boundary portion between the elastic packing and the metal plate in the obtained composite structure. The entry percentage of the elastic packing into the fine uneven structure, as calculated from the photograph of Fig. 7, was 10%. When the air tightness of the obtained composite structure was evaluated, it was a failure. Here, in Comparative Example 1, the surface-roughened aluminum alloy plate and the elastic packing were only overlapped and mechanically fastened, but were not bonded.

This application claims priority based on Japanese Application, Japanese Patent Application No. 2018-241444, filed on December 25, 2018, and the entirety of the disclosure is incorporated herein.

### REFERENCE SIGNS LIST

- 1:: Cooling unit
- 2:: Metal plate
- 3:: Resin tray
- 3a:: Side wall portion
- 3b:: Top surface portion of side wall portion
- 3c:: Top edge portion formed on side wall portion
- 4:: Elastic packing
- 4a:: Resin tray side concave groove for elastic packing
- 4b:: Metal plate side concave groove for elastic packing
- 5:: Flow path forming rib
- 5a:: Resin flow path forming rib
- 5b:: Metal flow path forming rib
- 6:: Mechanical fastening screw
- 7:: Flow path

## Claims

1. A cooling unit comprising:
a resin tray;
a metal plate provided on one surface of the resin tray; and
a flow path forming rib provided in a space between the resin tray and the metal plate,
wherein a top surface portion of a side wall portion of the resin tray and the metal plate are mechanically fastened via an elastic packing,
the elastic packing includes a bonding packing which is bonded to a metal plate surface, and
a fine uneven structure is formed on at least a bonding portion with the bonding packing in the metal plate surface.

2. The cooling unit according to claim 1,
wherein the elastic packing includes a thermoplastic elastomer.

3. The cooling unit according to claim 2,
wherein the thermoplastic elastomer includes a urethane-based thermoplastic elastomer.

4. The cooling unit according to claim 2 or 3,
wherein a tensile elastic modulus at 23°C of the elastic packing is 2 MPa or more and 500 MPa or less.

5. The cooling unit according to any one of claims 1 to 4,
wherein the resin tray and at least a part of the flow path forming rib are integrally formed of the same material.

6. The cooling unit according to any one of claims 1 to 5,
wherein the metal plate and at least a part of the flow path forming rib are integrally formed of the same material.

7. The cooling unit according to any one of claims 1 to 6,
wherein at least one elastic packing is arranged around a contact surface of the metal plate surface with the top surface portion.

8. The cooling unit according to any one of claims 1 to 7,
wherein the metal plate and the bonding packing are bonded by a portion of the bonding packing entering the fine uneven structure.

9. The cooling unit according to any one of claims 1 to 8,
wherein the bonding packing is injection bonded to the metal plate.

10. The cooling unit according to any one of claims 1 to 9,
wherein an entry percentage of the bonding packing into the fine uneven structure is 20% or more.

11. The cooling unit according to any one of claims 1 to 10,
wherein the mechanical fastening includes at least one type selected from screwing and riveting.

12. The cooling unit according to any one of claims 1 to 11,
wherein a top edge portion is formed on at least top surface portions of opposing side wall portions of the resin tray.

13. The cooling unit according to any one of claims 1 to 12,
wherein the metal plate is formed of at least one member selected from the group consisting of an aluminum member, an aluminum alloy member, a copper member, and a copper alloy member.

14. A manufacturing method for manufacturing the cooling unit according to any one of claims 1 to 13, the method comprising:
a step of injection bonding the bonding packing to the metal plate by injection molding the bonding packing on the fine uneven structure on the metal plate surface.

15. A structure comprising:
a heating element; and
the cooling unit according to any one of claims 1 to 13,
wherein the heating element is arranged on the metal plate surface in the cooling unit.
